# EUROPEAN PATENT SPECIFICATION

(11) **EP 4 203 002 B1**
(45) Date of publication and mention of the grant of the patent: **11.06.2025**
(21) Application number: 21932490.2
(22) Date of filing: 06.08.2021
(51) Int. Cl.: H01L 23/31, H01L 23/58, H01L 23/528

(54) **SEMICONDUCTOR STRUCTURE WITH A SEALING RING AND MANUFACTURING METHOD THEREFOR**
HALBLEITERSTRUKTUR MIT EINEM DICHTRING UND HERSTELLUNGSVERFAHREN DAFÜR
STRUCTURE SEMI-CONDUCTRICE AVEC UN ANNEAU D'ÉTANCHÉITÉ ET SON PROCÉDÉ DE FABRICATION

(30) Priority: 24.03.2021 CN 202110315842
(43) Date of publication of application: 28.06.2023
(73) Proprietor: Changxin Memory Technologies, Inc., Hefei, Anhui 230000 (CN)
(72) Inventor: YANG, Nianwang, Hefei, Anhui 230000 (CN); WANG, Mengmeng, Hefei, Anhui 230000 (CN)
(74) Representative: Gulde & Partner
(86) International application number: PCT/CN2021/111069
(87) International publication number: WO 2022/198878

(56) References cited:
- CN-A- 101 290 912
- CN-A- 105 448 866
- CN-A- 105 870 069
- CN-A- 105 870 069
- CN-A- 113 066 763
- US-A1- 2007 090 447
- US-A1- 2013 285 203
- US-A1- 2017 256 506
- US-A1- 2018 166 401
- US-B1- 8 093 719

## Description

### TECHNICAL FIELD

The present disclosure relates to the field of semiconductor manufacturing technology, and more particularly, to a semiconductor structure and a manufacturing method thereof.

### BACKGROUND

When a wafer is diced, a dicing mode of a dicing street may generate a certain mechanical stress on front and back surfaces of the wafer, which may cause chippings at an edge of a chip. The problem of chippings may reduce a mechanical strength of the chip, and an initial chip edge crack may be further spread in later packaging process or in the use of chip products, which may likely cause cracking of the chip, thus leading to failure of electrical properties of the chip. To protect internal circuits of the chip, prevent scratch damage, and improve reliability of the chip, a semiconductor structure such as a seal ring generally is designed at the periphery of the chip. Moreover, the seal ring structure also is capable of resisting gas and liquid erosion, which can prevent water vapor or other chemical contamination sources from permeating the chip to avoid causing damage to the chip.

At present, as sizes of semiconductor devices continue to decrease, roles of the seal ring at the periphery of the chip are becoming more and more important. However, the existing sealing rings are unable to provide better protection to the chip due to their poor stability and smaller interception area, and can no longer meet the requirements for protection of the chip.

Background may be found in US2013/285203A1, US8093719B1, US2017/256506A1, CN105870069A and US2018/166401A1. US2013/285203A1, in particular, discloses a semiconductor structure according to the precharacterizing part of claim 1.

### SUMMARY

The present application is defined in appended independent claims 1 and 5 to which reference should be made. Advantageous features are set out in the appended dependent claims.

### BRIEF DESCRIPTION OF THE DRAWINGS

To describe the technical solutions in the embodiments of the present disclosure or the existing technologies more clearly, the accompanying drawings required for describing the embodiments or the existing technologies will be briefly introduced below. Apparently, the accompanying drawings in the following description are merely some embodiments of the present disclosure. To those of ordinary skills in the art, other accompanying drawings may also be derived from these accompanying drawings without creative efforts.
FIG. 1 is a flow diagram of a method for manufacturing a semiconductor structure according to one example useful for understanding the present disclosure;
FIG. 2 is a schematic cross-sectional view of a bottom-layer dielectric layer according to one example useful for understanding the present disclosure;
FIG. 3 is a schematic cross-sectional view of a structure obtained in Step S2 of a method for manufacturing a semiconductor structure according to one example useful for understanding the present disclosure;
FIG. 4 is a flow diagram of Step S3 in a method for manufacturing a semiconductor structure according to one embodiment of the present disclosure;
FIG. 5 is a schematic cross-sectional view of a structure obtained in Step S32 of a method for manufacturing a semiconductor structure according to one embodiment of the present disclosure;
FIG. 6 is a schematic cross-sectional view of a structure obtained in Step S35 of a method for manufacturing a semiconductor structure according to one embodiment of the present disclosure;
FIG. 7 is a schematic cross-sectional view of a structure obtained in Step S38 of a method for manufacturing a semiconductor structure according to one embodiment of the present disclosure;
FIG. 8 is a schematic cross-sectional view of a structure obtained in Step S3 of a method for manufacturing a semiconductor structure according to one embodiment of the present disclosure, and also is a schematic diagram of a semiconductor structure according to one embodiment of the present disclosure;
FIG. 9 is a schematic cross-sectional view of a structure obtained in Step S4 of a method for manufacturing a semiconductor structure according to one embodiment of the present disclosure;
FIG. 10 is a schematic cross-sectional view of a structure obtained in Step S6 of a method for manufacturing a semiconductor structure according to one embodiment of the present disclosure;
FIG. 11 is a schematic cross-sectional view of a structure obtained in Step S7 of a method for manufacturing a semiconductor structure according to one embodiment of the present disclosure;
FIG. 12 is a schematic cross-sectional view of a structure obtained in Step S8 of a method for manufacturing a semiconductor structure according to one embodiment of the present disclosure;
FIG. 13 is a schematic cross-sectional view of a structure obtained in Step S9 of a method for manufacturing a semiconductor structure according to one embodiment of the present disclosure; and
FIG. 14 is a schematic cross-sectional view of a structure obtained in Step S10 of a method for manufacturing a semiconductor structure according to one embodiment of the present disclosure, and also is a schematic diagram of a semiconductor structure according to one embodiment of the present disclosure.

### DETAILED DESCRIPTION

For ease of understanding the present disclosure, the present disclosure will be described more fully hereinafter with reference to the accompanying drawings. Some embodiments of the present disclosure are provided in the accompanying drawings. The present disclosure may, however, be embodied in many different forms and should not be limited to the embodiments set forth herein. Rather, these embodiments are provided so that the present disclosure will be more thorough and complete.

Unless otherwise defined, all technical and scientific terms employed herein have the same meaning as commonly understood by one of ordinary skill in the art to which the present disclosure belongs. The terms employed in the specification of the present disclosure are merely for the purpose of describing some embodiments and are not intended for limiting the present disclosure.

It should be understood that when an element or layer is referred to as being "on", "adjacent to", "connected to" or "coupled to" other elements or layers, it may be directly on, adjacent to, connected or coupled to the other elements or layers, or intervening elements or layers may be present. In contrast, when an element is referred to as being "directly on", "directly adjacent to", "directly connected to" or "directly coupled to" other elements or layers, there are no intervening elements or layers present. It should be understood that although the terms first, second, third, etc. may be employed to describe various elements, components, regions, layers, doping types and/or sections, these elements, components, regions, layers, doping types and/or sections should not be limited by these terms. These terms are only employed to distinguish one element, component, region, layer, doping type, or section from another element, component, region, layer, doping type, or section. Thus, without departing from the teachings of the present disclosure, a first element, component, region, layer, doping type or portion discussed below may be represented as a second element, component, region, layer or portion. For example, a first doping type may be a second doping type, and similarly, the second doping type may be the first doping type. Furthermore, the first doping type and the second doping type may be different doping types. For example, the first doping type may be a P type and the second doping type may be an N type, or the first doping type may be the N type and the second doping type may be the P type.

Spatially relative terms such as "below", "under", "lower", "beneath", "above", "upper" and the like may be used herein to describe relationships between one element or feature as shown in the figures and another element(s) or feature(s). It should be understood that the spatially relative terms may be intended to encompass different orientations of a device in use or operation in addition to the orientation depicted in the figures. For example, if the device in the figures is turned over, elements or features described as "under", "beneath" or "below" other elements would then be oriented "above" the other elements or features. Thus, the example term "under", "below" or "beneath" may encompass both an orientation of above and below. In addition, the device may also be otherwise oriented (for example, rotated 90 degrees or at other orientations) and the spatially descriptors used herein should be interpreted accordingly.

As used herein, the singular forms of "a", "one" and "said/the" are also intended to include plural forms, unless the context clearly indicates otherwise. It should also be understood that the terms "comprising" and/or "including", when used in this specification, may determine the presence of the described features, integers, steps, operations, elements and/or components, but do not preclude the presence or addition of one or more other features, integers, steps, operations, elements, components, and/or groups thereof. Meanwhile, as used herein, the term "and/or" includes any and all combinations of related listed items.

Embodiments of the present disclosure are described herein with reference to cross-sectional illustrations serving as schematic illustrations of embodiments (and intermediate structures) of the present disclosure. As such, variations from the shapes of the illustrations as a result, for example, of manufacturing techniques and/or tolerances, may be expected. Thus, embodiments of the present disclosure should not be construed as being limited to particular shapes of regions illustrated herein but may include deviations in shapes that result, for example, from manufacturing technologies. Thus, regions illustrated in the figures are schematic in nature and their shapes do not necessarily illustrate the actual shape of a region of the device and do not limit the scope of the present disclosure.

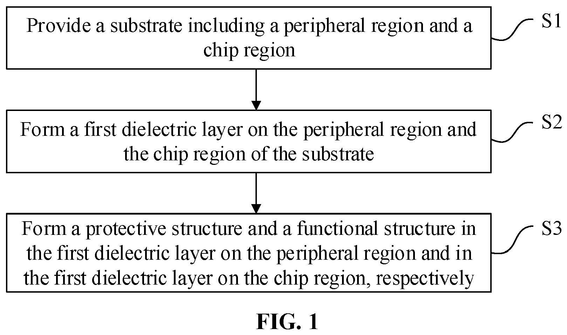

With reference to FIG. 1, an example useful for understanding the present disclosure provides a method for manufacturing a semiconductor structure, wherein the method includes following steps:
S1: providing a substrate (not shown in the figure), which includes a peripheral region and a chip region;
S2: forming a first dielectric layer 2 on the peripheral region and the chip region of the substrate; and
S3: forming a sealing ring structure 21 and a functional structure 22 in the first dielectric layer 2 on the peripheral region and in the first dielectric layer 2 on the chip region, respectively.

The sealing ring structure 21 comprises a first subportion 211, a second subportion 212 and a third subportion 213 stacked in sequence. The functional structure 22 comprises a fourth subportion 224 and a fifth subportion 225 stacked in sequence. A total height of the first subportion 211, the second subportion 212 and the third subportion 213 is equal to a total height of the fourth subportion 224 and the fifth subportion 225.

The semiconductor structure formed by means of the method for manufacturing a semiconductor structure provided in the above example has a more stable structure, has a larger interception area, provides better protection to the chip, and has a simpler technological process.

The substrate may include, but is not limited to, a silicon substrate The substrate may also be a gallium nitride substrate, an indium phosphide substrate, or a sapphire substrate, etc.

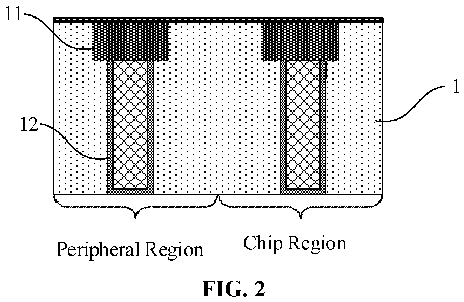

Before Step S2, the method may include:
forming a bottom-layer dielectric layer 1 on the peripheral region and the chip region of the substrate, as shown in FIG. 2.

It is to be noted that the bottom-layer dielectric layer 1 may be formed on the substrate, as shown in FIG. 2, a bottom-layer metal layer 11 and an interconnection structure 12 are formed in the bottom-layer dielectric layer 1. In some embodiments, in one embodiment, a through hole is respectively formed in the peripheral region and the chip region of the bottom-layer dielectric layer 1, and the interconnection structure 12 and the bottom-layer metal layer 11 are stacked sequentially from bottom to top in the through hole.

The interconnection structure 12 may be a single-layer structure, a stacked-layer structure or other structure, but the interconnection structure 12 in this example is not limited thereto. A material of the interconnection structure 12 may comprise one or more of titanium, titanium nitride, or tungsten, etc. This example does not limit the material of the interconnection structure 12. The interconnection structure 12 includes a conductive metal and a barrier layer, wherein the conductive metal may include, but is not limited to, tungsten, ruthenium, and the like, and the barrier layer may include, but is not limited to, titanium nitride, titanium, and the like.

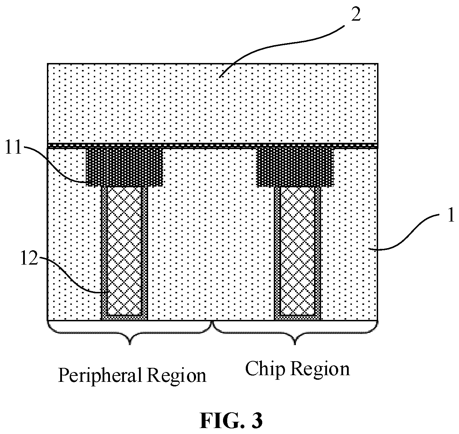

In accordance with embodiments of the invention, Step S2 includes:
forming a first dielectric layer 2 on the peripheral region and the chip region of the bottom-layer dielectric layer 1, as shown in FIG. 3.

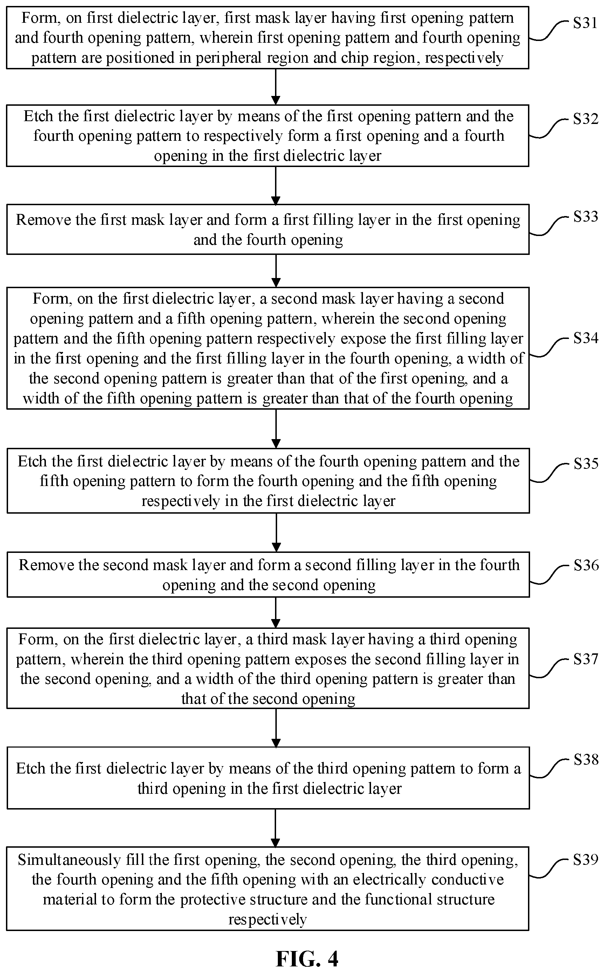

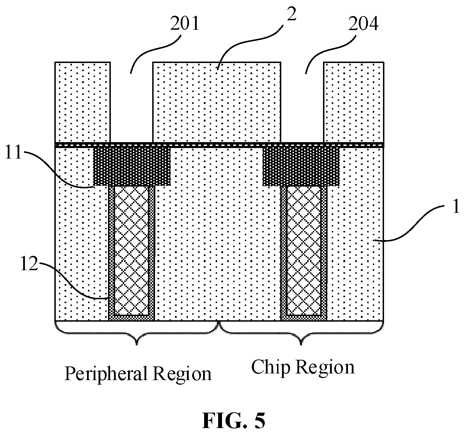

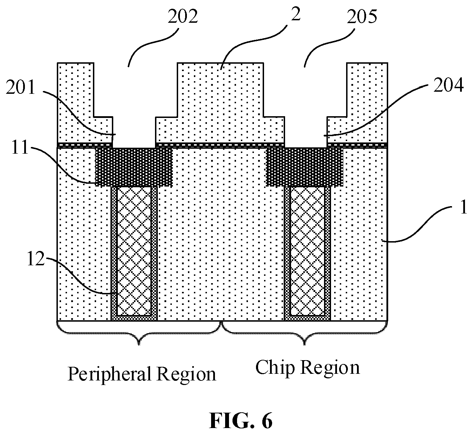

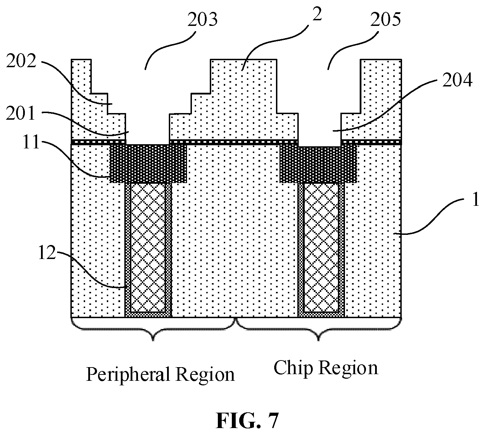

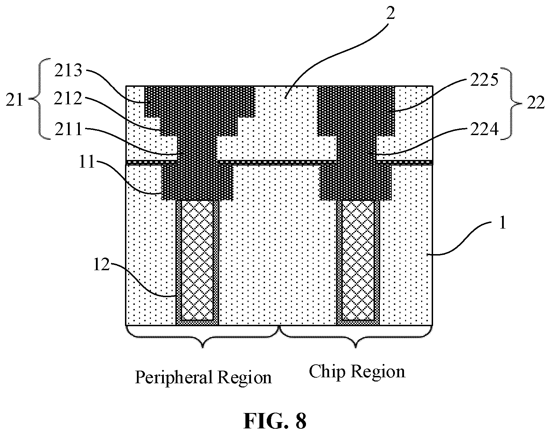

For Step S3, as shown in FIG. 4, in one embodiment, Step S3 may include following steps:
S31: forming, on the first dielectric layer 2, a first mask layer having a first opening pattern and a fourth opening pattern, wherein the first opening pattern and the fourth opening pattern are positioned in the peripheral region and the chip region, respectively;
S32: etching the first dielectric layer 2 by means of the first opening pattern and the fourth opening pattern to respectively form a first opening 201 and a fourth opening 204 in the first dielectric layer 2, as shown in FIG. 5;
S33: removing the first mask layer and forming a first filling layer in the first opening 201 and the fourth opening 204;
S34: forming, on the first dielectric layer 2, a second mask layer having a second opening pattern and a fifth opening pattern, wherein the second opening pattern and the fifth opening pattern respectively expose the first filling layer in the first opening 201 and the first filling layer in the fourth opening 204, in a direction parallel to a surface of the substrate, a width of the second opening pattern is greater than that of the first opening 201, and in a direction parallel to a surface of the substrate, a width of the fifth opening pattern is greater than that of the fourth opening 204;
S35: etching the first dielectric layer 2 by means of the second opening pattern and the fifth opening pattern to form the second opening 202 and the fifth opening 205 respectively in the first dielectric layer 2, as shown in FIG. 6;
S36: removing the second mask layer and forming a second filling layer in the second opening 202 and the fifth opening 205;
S37: forming, on the first dielectric layer 2, a third mask layer having a third opening pattern, wherein the third opening pattern exposes the second filling layer in the second opening 202, and in a direction parallel to a surface of the substrate, a width of the third opening pattern is greater than that of the second opening 202;
S38: etching the first dielectric layer 2 by means of the third opening pattern to form a third opening 203 in the first dielectric layer 2, as shown in FIG. 7; and
S39: simultaneously filling the first opening 201, the second opening 202, the third opening 203, the fourth opening 204 and the fifth opening 205 with an electrically conductive material to form the sealing ring structure 21 and the functional structure 22 respectively, as shown in FIG. 8.

According to embodiments of the invention, the width of the first opening 201 is the same as that of the fourth opening 204, and the width of the second opening 202 is the same as that of the fifth opening 205.

Further, in one embodiment, an opening depth of the first opening 201 is the same as that of the fourth opening 204, and an opening depth of the second opening 202 is the same as that of the fifth opening 205.

In one embodiment, the opening depth of the first opening 201 is greater than that of the second opening 202, and the opening depth of the second opening 202 is greater than that of the third opening 203.

According to embodiments of the invention, the width of the first opening 201 is less than that of the second opening 202, the width of the second opening 202 is less than that of the third opening 203, and the width of the fourth opening 204 is less than that of the fifth opening 205.

According to embodiments of the invention, a total depth of the first opening 201, the second opening 202 and the third opening 203 is the same as a total depth of the fourth opening 204 and the fifth opening 205.

The electrically conductive material in the first opening 201 is the first subportion 211, the electrically conductive material in the second opening 202 is the second subportion 212, the electrically conductive material in the third opening 203 is the third subportion 213, the electrically conductive material in the fourth opening 204 is the fourth subportion 224, and the electrically conductive material in the fifth opening 205 is the fifth subportion 225.

In some embodiments, in one embodiment, the material of the sealing ring structure 21 may include, but is not limited to, copper.

In some embodiments, the electrically conductive material may be copper, and an initial copper layer is formed simultaneously, by means of electroplating, in the first opening 201, the second opening 202, the third opening 203, the fourth opening 204, the fifth opening 205, and the first dielectric layer 2. Next, the initial copper layer above the first dielectric layer 2 is removed by means of chemical mechanical grinding to form the sealing ring structure 21 and the functional structure 22 respectively. as shown in FIG. 8. The sealing ring structure 21 may be formed separately in a copper-metal interconnection layer to enhance the protective effect of a copper-metal protection ring while saving production costs.

The first dielectric layer 2 formed is a single-layer structure, and the sealing ring structure 21 formed includes N subportions stacked sequentially, wherein N is an integer greater than 3.

According to embodiments of the invention, the first dielectric layer 2 is a single-layer structure. In one embodiment, the first dielectric layer 2 may be a silicon nitride layer and a silicon oxide layer stacked sequentially from bottom to top, and the sealing ring structure 21 formed is positioned in the silicon oxide layer.

The semiconductor structure formed by means of the method for manufacturing g a semiconductor structure provided in the above embodiment has more subportions, which increases its interception area and further enhances the protection of this structure for the chip.

In one embodiment, in a direction parallel to a surface of the substrate, widths of the N subportions stacked in sequence are sequentially increased.

The semiconductor structure formed by means of the method for manufacturing a semiconductor structure provided in the above embodiment has N subportions stacked in sequence, and the widths of the N subportions are sequentially increased, to ensure the structure to be more stable.

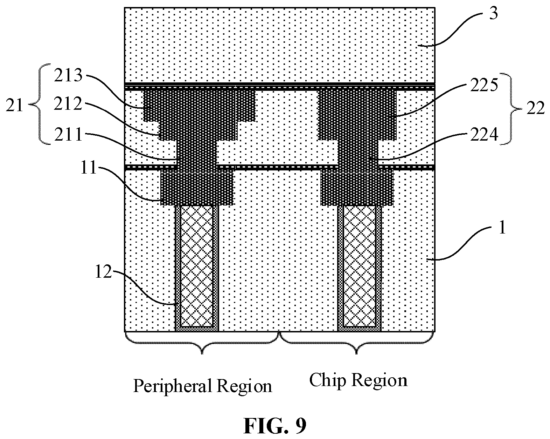

In one embodiment, after Step S3, the method may also include:
S4: forming a second dielectric layer 3 on the first dielectric layer 2, as shown in FIG. 9.

In one embodiment, the second dielectric layer 3 is a single-layer structure. In other embodiments, the second dielectric layer 3 may also be a stacked-layer structure. This embodiment does not limit the structure and arrangement of the second dielectric layer 3. In one embodiment, the second dielectric layer 3 may include one or more of a silicon nitride layer, a silicon oxide layer, and so on. This embodiment does not limit the material of the second dielectric layer 3. In some embodiments, in one embodiment, the second dielectric layer 3 may be the silicon nitride layer and the silicon oxide layer stacked sequentially from bottom to top.

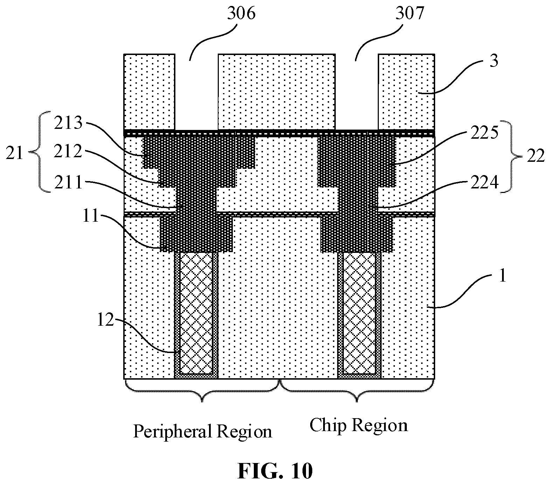

In one embodiment, after Step S4, the method may further comprise:
S5: forming, on the second dielectric layer 3, a fourth mask layer having a sixth opening pattern and a seventh opening pattern, wherein the sixth opening pattern and the seventh opening pattern are positioned in the peripheral region and the chip region, respectively; and
S6: etching the second dielectric layer 3 by means of the sixth opening pattern and the seventh opening pattern to form a sixth opening 306 and a seventh opening 307 respectively in the second dielectric layer 3, as shown in FIG. 10, wherein the sixth opening 306 and the seventh opening 307 are positioned in the peripheral region and the chip region, respectively.

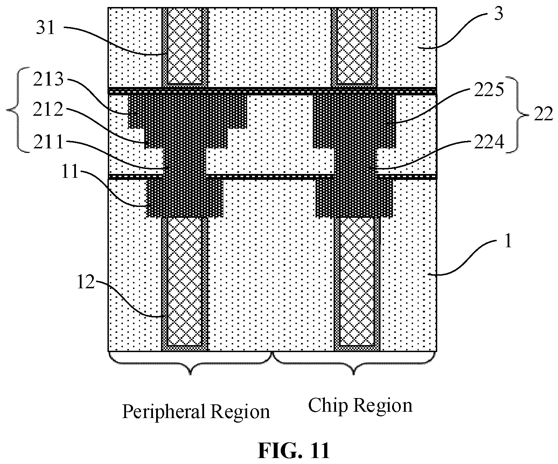

In one embodiment, after Step S6, the method may further include:
S7: forming a top-layer interconnection structure 31 in the sixth opening 306 and the seventh opening 307, as shown in FIG. 11.

In one embodiment, the top-layer interconnection structure 31 may be a single-layer structure, a stacked-layer structure, or other structure, and this embodiment does not limit the structure and arrangement of the top-layer interconnection structure 31. In one embodiment, a material of the top-layer interconnection structure 31 may include one or more of aluminum, titanium, titanium nitride, or tungsten, etc. However, this embodiment does not limit the material of the top-layer interconnection structure 31. In one embodiment, the top-layer interconnection structure 31 includes a titanium layer and a tungsten layer stacked sequentially from bottom to top.

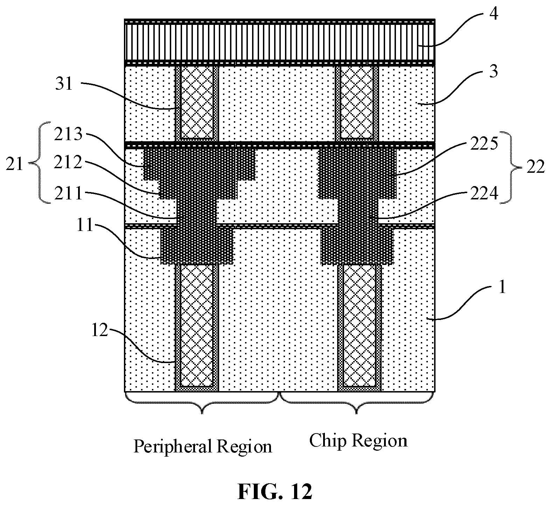

In one embodiment, after Step S7, the method may further comprise:
S8: forming a top-layer metal material layer 4 on the second dielectric layer 3, as shown in FIG. 12.

In one embodiment, the top-layer metal material layer 4 formed is a single-layer structure or a stacked-layer structure, and this embodiment does not limit the structure and arrangement of the top-layer metal material layer 4. In one embodiment, the top-layer metal material layer 4 may comprise a stacked-layer structure where the titanium layer and the aluminum layer are alternately stacked in sequence or a stacked-layer structure where the titanium nitride layer and the aluminum layer are alternately stacked in sequence, and a bottom layer and a top layer of the top-layer metal material layer are both the titanium layers or the titanium nitride layers.

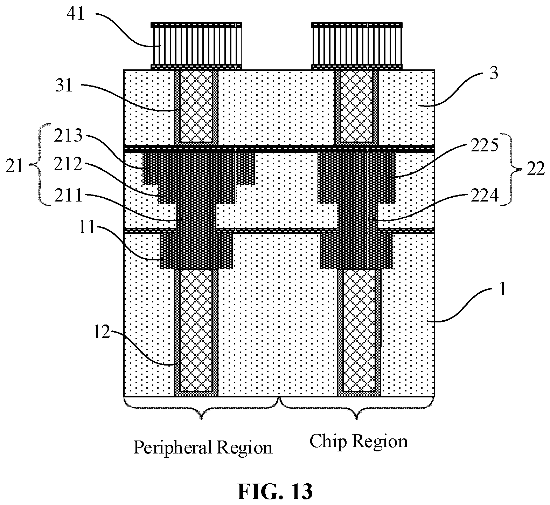

In one embodiment, after Step S8, the method may further comprise:
S9: etching the top-layer metal material layer 4 to form a top-layer metal layer 41 and expose a portion of the second dielectric layer 3, as shown in FIG. 13.

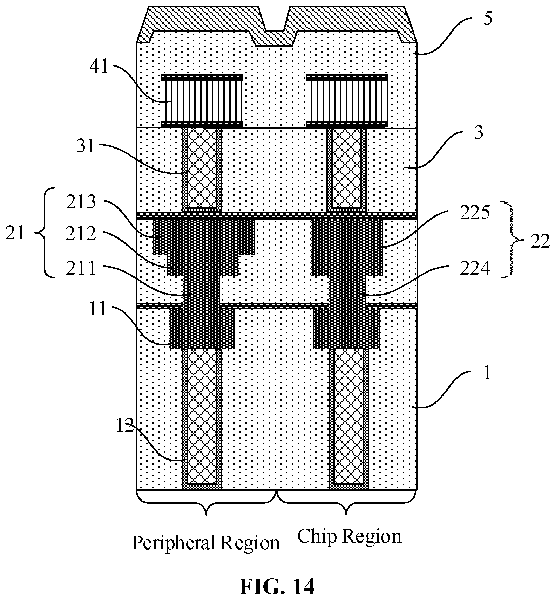

In one embodiment, after Step S9, the method may further comprise:
S10: forming a top-layer dielectric layer 5 over the second dielectric layer 3 and the top-layer metal layer 41, as shown in FIG. 14.

In one embodiment, the top-layer dielectric layer 5 formed may be a single-layer structure or a stacked-layer structure, and this embodiment does not limit the structure of the top-layer dielectric layer 5. In some embodiments, in one embodiment, the top-layer dielectric layer 5 may be a silicon oxide layer and a silicon nitride layer stacked sequentially from bottom to top.

It should be understood that although the steps in the flow diagrams of FIG. 1 and FIG. 4 are shown sequentially as indicated by the arrows, these steps are not necessarily performed sequentially in the order indicated by the arrows. It should be understood that unless expressly stated herein, the execution of these steps is not strictly limited in sequence, and these steps may be performed in other orders. Moreover, at least some of the steps in FIG. 1 and FIG. 4 may include a plurality of steps or a plurality of stages, which are not necessarily performed at the same moment, but may be executed at different moments, and the order of execution of these steps or stages is not necessarily performed sequentially, but may be performed alternately or alternately with at least a portion of the steps or stages of other steps or other steps.

With continued reference to FIG. 8, the present disclosure provides a semiconductor structure, comprising:
a substrate, the substrate comprising a peripheral region and a chip region;
a first dielectric layer 2 arranged on the peripheral region and the chip region of the substrate; and
a sealing ring structure 21 and a functional structure 22 in the first dielectric layer 2 on the peripheral region and in the first dielectric layer 2 on the chip region, respectively.

The sealing ring structure 21 comprises a first subportion 211, a second subportion 212 and a third subportion 213 stacked in sequence. The functional structure 22 comprises a fourth subportion 224 and a fifth subportion 225 stacked in sequence. A total height of the first subportion 211, the second subportion 212 and the third subportion 213 is equal to a total height of the fourth subportion 224 and the fifth subportion 225.

The semiconductor structure provided by the above embodiment has a more stable structure, has a larger interception area, and provides better protection to a chip.

In one embodiment, the substrate may include, but is not limited to, a silicon substrate. In other embodiments, the substrate may also be a gallium nitride substrate, an indium phosphide substrate, or a sapphire substrate, etc.

In one embodiment, the bottom-layer dielectric layer 1 is formed on the substrate, the first dielectric layer 2 is formed on the peripheral region and the chip region of the bottom-layer dielectric layer 1, and the bottom-layer metal layer 11 and the interconnection structure 12 are formed in the bottom-layer dielectric layer 1. In some embodiments, in one embodiment, a through hole is respectively formed in the peripheral region and the chip region of the bottom-layer dielectric layer 1, and the interconnection structure 12 and the bottom-layer metal layer 11 are stacked sequentially from bottom to top in the through hole.

According to embodiments of the invention, the interconnection structure 12 is a stacked-layer structure 12. In one embodiment, a material of the interconnection structure 12 may include one or more of titanium, titanium nitride, or tungsten, etc. This embodiment does not limit the material of the interconnection structure 12. In one embodiment, the interconnection structure 12 comprises a conductive metal and a barrier layer, wherein the conductive metal comprises tungsten, ruthenium, and the like, and the barrier layer comprises titanium nitride, titanium, and the like.

According to embodiments of the present invention, the first dielectric layer 2, in which the sealing ring and functional structures are positioned, is a single-layer structure. In other embodiments, the first dielectric layer 2 may also be a stacked-layer structure. For example, and without limiting the material of the first dielectric layer, the first dielectric layer 2 may include one or more of a silicon nitride layer, a silicon oxide layer, and so on. In one embodiment, the first dielectric layer 2 may be the silicon nitride layer and the silicon oxide layer stacked sequentially from bottom to top, and the sealing ring structure 21 formed is positioned in the silicon oxide layer.

According to embodiments of the invention, in a direction parallel to a surface of the substrate, the width of the second subportion 212 is greater than that of the first subportion 211, and in a direction parallel to a surface of the substrate, the width of the third subportion 213 is greater than that of the second subportion 212.

The width of the first subportion 211 is the same as that of the fourth subportion 224, and the width of the second subportion 212 is the same as that of the fifth subportion 225.

The first subportion 211, the second subportion 212, and the third subportion 213 are integrally formed. The fourth subportion 224 and the fifth subportion 225 are integrally formed.

In one embodiment, the sealing ring structure 21 includes N subportions stacked sequentially, wherein N is an integer greater than 3.

The semiconductor structure provided in the above embodiment has more subportions, which further increases the interception area and further enhances the protection of this structure for the chip.

In one embodiment, widths of the N subportions stacked in sequence are sequentially increased.

The semiconductor structure provided in the above embodiment has N subportions stacked in sequence, and the widths of the N subportions are sequentially increased, to ensure the structure to be more stable.

In some embodiments, in one embodiment, the first subportion 211, the second subportion 212, and the third subportion 213 are all annular wall structures. The fourth subportion 224 is a conductive plug structure, and the fifth subportion 225 is a conductive wire structure.

In one embodiment, the semiconductor structure further comprises a bottom metal layer positioned below the sealing ring structure 21. In some embodiments, the material of the bottom-layer metal layer may include, but is not limited to, tungsten.

With continued reference to FIG. 9, in one embodiment, the semiconductor structure further comprises:
a second dielectric layer 3 arranged on the first dielectric layer 2.

In one embodiment, the second dielectric layer 3 is a single-layer structure. In other embodiments, the first dielectric layer 2 may also be a stacked-layer structure. This embodiment does not limit the structure and arrangement of the second dielectric layer 3. In one embodiment, the second dielectric layer 3 may include one or more of a silicon nitride layer, a silicon oxide layer, and so on. This embodiment does not limit the material of the second dielectric layer 3. In some embodiments, in one embodiment, the second dielectric layer 3 may be the silicon nitride layer and the silicon oxide layer stacked sequentially from bottom to top.

Referring to FIG. 11, in one embodiment, the semiconductor structure further comprises:
a sixth opening 306;
a seventh opening 307, both the sixth opening 306 and the seventh opening 307 being positioned in the second dielectric layer 3 and positioned in the peripheral region and the chip region, respectively; and
a top-layer interconnection structure 31 arranged in the sixth opening 306 and the seventh opening 307.

In one embodiment, the top-layer interconnection structure 31 may be a single-layer structure, a stacked-layer structure, or other structure, and this embodiment does not limit the structure and arrangement of the top-layer interconnection structure 31. In one embodiment, a material of the top-layer interconnection structure 31 may include one or more of titanium, titanium nitride, or tungsten, etc. However, this embodiment does not limit the material of the top-layer interconnection structure 31. In one embodiment, the top-layer interconnection structure 31 includes a titanium layer and a tungsten layer stacked sequentially from bottom to top.

With continued reference to FIG. 12, in one embodiment, the semiconductor structure further comprises:
a top-layer metal layer 41 arranged on an upper surface of the second dielectric layer 3.

In one embodiment, the top-layer metal layer 41 is a single-layer structure or a stacked-layer structure, and this embodiment does not limit the structure and arrangement of the top-layer metal layer 41. In one embodiment, the top-layer metal material layer 41 may comprise a stacked-layer structure where the titanium layer and the aluminum layer are alternately stacked in sequence or a stacked-layer structure where the titanium nitride layer and the aluminum layer are alternately stacked in sequence, and a bottom layer and a top layer of the top-layer metal material layer are both the titanium layers or the titanium nitride layers.

With continued reference to FIG. 14, in one embodiment, the semiconductor structure further comprises:
a top-layer dielectric layer 5 arranged on the upper surface of the second dielectric layer 3 and the upper surface of the top-layer metal layer 41.

In one embodiment, the top-layer dielectric layer 5 formed may be a single-layer structure or a stacked-layer structure, and this embodiment does not limit the structure of the top-layer dielectric layer 5. In some embodiments, in one embodiment, the top-layer dielectric layer 5 may be a silicon oxide layer and a silicon nitride layer stacked sequentially from bottom to top.

Technical features of the above embodiments may be combined. For simplicity, all possible combinations of the technical features in the above embodiments are not described. However, as long as the combination of these technical features is not contradictory, it shall be deemed to be within the scope recorded in this specification, which is defined solely by the appended claims.

The above embodiments merely express a plurality of implementations of the present disclosure, and descriptions thereof are relatively concrete and detailed. However, these embodiments are not thus construed as limiting the patent scope of the present disclosure. It is to be pointed out that for persons of ordinary skill in the art, some modifications and improvements may be made which shall be regarded as falling within the scope of protection of the present disclosure. Thus, the scope of protection of the present disclosure is defined solely by the appended claims.

## Claims

1. A semiconductor structure, comprising:
a substrate, the substrate comprising a peripheral region and a chip region;
a first dielectric layer(2) positioned on the peripheral region and the chip region of the substrate; and
a sealing ring structure(21) and a functional structure(22) respectively positioned in the first dielectric layer(2) on the peripheral region and in the first dielectric layer(2) on the chip region;
wherein the sealing ring structure and the functional structure are formed by electrically conductive material;
wherein the sealing ring structure(21) comprises a first subportion(211), a second subportion(212) and a third subportion(213) stacked in sequence, the functional structure(22) comprising a fourth subportion(224) and a fifth subportion(225) stacked in sequence, a total height of the first subportion(211), the second subportion(212) and the third subportion(213) being equal to a total height of the fourth subportion(224) and the fifth subportion(225);
**characterized in that**, in a direction parallel to a surface of the substrate, a width of the second subportion(212) is greater than a width of the first subportion(211); and
in a direction parallel to a surface of the substrate, a width of the third subportion(213) is greater than the width of the second subportion(212);
in a direction parallel to a surface of the substrate, the width of the first subportion(211) is equal to a width of the fourth subportion(224); and
in a direction parallel to a surface of the substrate, the width of the second subportion(212) is equal to a width of the fifth subportion(2);
the first subportion(211), the second subportion(212) and the third subportion(213) are integrally formed; and
the fourth subportion(224) and the fifth subportion(225) are integrally formed and
the first dielectric layer(2) is a single-layer structure.

2. The semiconductor structure according to claim 1, wherein
the sealing ring structure(21) comprises N subportions stacked in sequence, the N being an integer greater than 3.

3. The semiconductor structure according to claim 2, wherein
in a direction parallel to a surface of the substrate, widths of the N subportions stacked in sequence increase successively.

4. The semiconductor structure according to claim 1, further comprising:
a bottom metal layer(11) positioned below the sealing ring structure(21) and a top-layer interconnection structure (31) positioned above the sealing ring structure(21), respectively; wherein
a material of the sealing ring structure comprises copper, a material of the bottom metal layer(11) comprising tungsten, and a material of the top-layer interconnection structure (31) comprising tungsten or aluminum.

5. A method for manufacturing a semiconductor structure, comprising:
providing a substrate(S1), the substrate comprising a peripheral region and a chip region;
forming(S2) a first dielectric layer(2) on the peripheral region and the chip region of the substrate; and
forming(S3) a sealing ring structure(21) and a functional structure(22) respectively in the first dielectric layer(2) on the peripheral region and in the first dielectric layer on the chip region;
wherein the sealing ring structure and the functional structure are formed by electrically conductive material;
wherein the sealing ring structure comprises a first subportion(211), a second subportion(212) and a third subportion(213) stacked in sequence, the functional structure(22) comprising a fourth subportion(224) and a fifth subportion(225) stacked in sequence, a total height of the first subportion(211), the second subportion(212) and the third subportion(213) being equal to a total height of the fourth subportion(224) and the fifth subportion(225);
**characterized in that**, in a direction parallel to a surface of the substrate, a width of the second subportion(212) is greater than a width of the first subportion(211); and
in a direction parallel to a surface of the substrate, a width of the third subportion(213) is greater than the width of the second subportion(212);
in a direction parallel to a surface of the substrate, the width of the first subportion(211) is equal to a width of the fourth subportion(224); and
in a direction parallel to a surface of the substrate, the width of the second subportion(212) is equal to a width of the fifth subportion(2);
the first subportion(211), the second subportion(212) and the third subportion(213) are integrally formed; and
the fourth subportion(224) and the fifth subportion(225) are integrally formed and
the first dielectric layer(2) is a single-layer structure.

6. The method for manufacturing the semiconductor structure according to claim 5, wherein
the sealing ring structure(21) formed comprises N subportions stacked in sequence, the N being an integer greater than 3.

7. The method for manufacturing the semiconductor structure according to claim 6, wherein
in a direction parallel to a surface of the substrate, widths of the N subportions stacked in sequence increase successively.

## Patentansprüche

1. Halbleiterstruktur, umfassend:
ein Substrat, wobei das Substrat einen Umfangsbereich und einen Chipbereich umfasst;
eine erste dielektrische Schicht (2), die auf dem Umfangsbereich und dem Chipbereich des Substrats positioniert ist; und
eine Dichtungsringstruktur (21) und eine funktionelle Struktur (22), die jeweils in der ersten dielektrischen Schicht (2) auf dem Umfangsbereich und in der ersten dielektrischen Schicht (2) auf dem Chipbereich positioniert sind;
wobei die Dichtungsringstruktur und die funktionelle Struktur aus elektrisch leitfähigem Material ausgebildet sind;
wobei die Dichtungsringstruktur (21) einen ersten Teilabschnitt (211), einen zweiten Teilabschnitt (212) und einen dritten Teilabschnitt (213) umfasst, die nacheinander gestapelt sind, wobei die funktionelle Struktur (22) einen vierten Teilabschnitt (224) und einen fünften Teilabschnitt (225) umfasst, die nacheinander gestapelt sind, eine Gesamthöhe des ersten Teilabschnitts (211), des zweiten Teilabschnitts (212) und des dritten Teilabschnitts (213) gleich einer Gesamthöhe des vierten Teilabschnitts (224) und des fünften Teilabschnitts (225) ist;
**dadurch gekennzeichnet, dass** in einer Richtung parallel zu einer Fläche des Substrats eine Breite des zweiten Teilabschnitts (212) größer als eine Breite des ersten Teilabschnitts (211) ist; und
in einer Richtung parallel zu einer Fläche des Substrats eine Breite des dritten Teilabschnitts (213) größer als die Breite des zweiten Teilabschnitts (212) ist;
in einer Richtung parallel zu einer Fläche des Substrats die Breite des ersten Teilabschnitts (211) gleich einer Breite des vierten Teilabschnitts (224) ist; und
in einer Richtung parallel zu einer Fläche des Substrats die Breite des zweiten Teilabschnitts (212) gleich einer Breite des fünften Teilabschnitts (2) ist;
der erste Teilabschnitt (211), der zweite Teilabschnitt (212) und der dritte Teilabschnitt (213) einstückig ausgebildet sind; und
der vierte Teilabschnitt (224) und der fünfte Teilabschnitt (225) einstückig ausgebildet sind und
die erste dielektrische Schicht (2) eine einschichtige Struktur ist.

2. Halbleiterstruktur gemäß nach Anspruch 1, wobei
die Dichtungsringstruktur (21) N Teilabschnitte umfasst, die nacheinander gestapelt sind, wobei N eine ganze Zahl größer als 3 ist.

3. Halbleiterstruktur gemäß nach Anspruch 2, wobei
in einer Richtung parallel zu einer Fläche des Substrats die Breiten der nacheinander gestapelten N Teilabschnitte sukzessive zunehmen.

4. Halbleiterstruktur nach Anspruch 1, ferner umfassend:
eine untere Metallschicht (11), die unterhalb der Dichtungsringstruktur (21) positioniert ist, bzw. eine Oberschicht-Verbindungsstruktur (31), die oberhalb der Dichtungsringstruktur (21) positioniert ist; wobei
ein Material der Dichtungsringstruktur Kupfer umfasst, ein Material der unteren Metallschicht (11) Wolfram umfasst und ein Material der Oberschicht-Verbindungsstruktur (31) Wolfram oder Aluminium umfasst.

5. Verfahren zum Herstellen einer Halbleiterstruktur, umfassend:
Bereitstellen eines Substrats (S1), wobei das Substrat einen Umfangsbereich und einen Chipbereich umfasst;
Ausbilden (S2) einer ersten dielektrischen Schicht (2) auf dem Umfangsbereich und dem Chipbereich des Substrats; und
Ausbilden (S3) einer Dichtungsringstruktur (21) und einer funktionellen Struktur (22) in der ersten dielektrischen Schicht (2) auf dem Umfangsbereich bzw. in der ersten dielektrischen Schicht auf dem Chipbereich;
wobei die Dichtungsringstruktur und die funktionelle Struktur aus elektrisch leitfähigem Material ausgebildet sind;
wobei die Dichtungsringstruktur einen ersten Teilabschnitt (211), einen zweiten Teilabschnitt (212) und einen dritten Teilabschnitt (213) umfasst, die nacheinander gestapelt sind, wobei die funktionelle Struktur (22) einen vierten Teilabschnitt (224) und einen fünften Teilabschnitt (225) umfasst, die nacheinander gestapelt sind, eine Gesamthöhe des ersten Teilabschnitts (211), des zweiten Teilabschnitts (212) und des dritten Teilabschnitts (213) gleich einer Gesamthöhe des vierten Teilabschnitts (224) und des fünften Teilabschnitts (225) ist;
**dadurch gekennzeichnet, dass** in einer Richtung parallel zu einer Fläche des Substrats eine Breite des zweiten Teilabschnitts (212) größer als eine Breite des ersten Teilabschnitts (211) ist; und
in einer Richtung parallel zu einer Fläche des Substrats eine Breite des dritten Teilabschnitts (213) größer als die Breite des zweiten Teilabschnitts (212) ist;
in einer Richtung parallel zu einer Fläche des Substrats die Breite des ersten Teilabschnitts (211) gleich einer Breite des vierten Teilabschnitts (224) ist; und
in einer Richtung parallel zu einer Fläche des Substrats die Breite des zweiten Teilabschnitts (212) gleich einer Breite des fünften Teilabschnitts (2) ist;
der erste Teilabschnitt (211), der zweite Teilabschnitt (212) und der dritte Teilabschnitt (213) einstückig ausgebildet sind; und
der vierte Teilabschnitt (224) und der fünfte Teilabschnitt (225) einstückig ausgebildet sind und
die erste dielektrische Schicht (2) eine einschichtige Struktur ist.

6. Verfahren zum Herstellen einer Halbleiterstruktur nach Anspruch 5, wobei
die ausgebildete Dichtungsringstruktur (21) N Teilabschnitte umfasst, die nacheinander gestapelt sind, wobei N eine ganze Zahl größer als 3 ist.

7. Verfahren zum Herstellen einer Halbleiterstruktur nach Anspruch 6, wobei
in einer Richtung parallel zu einer Fläche des Substrats die Breiten der nacheinander gestapelten N Teilabschnitte sukzessive zunehmen.

## Revendications

1. Structure semi-conductrice comprenant :
un substrat, le substrat comprenant une région périphérique et une région de puce ;
une première couche diélectrique (2) positionnée sur la région périphérique et la région de puce du substrat ; et
une structure d'anneau d'étanchéité (21) et une structure fonctionnelle (22) respectivement positionnées dans la première couche diélectrique (2) sur la région périphérique et dans la première couche diélectrique (2) sur la région de puce ;
dans laquelle la structure d'anneau d'étanchéité et la structure fonctionnelle sont formées par un matériau électriquement conducteur ;
dans laquelle la structure d'anneau d'étanchéité (21) comprend une première sous-partie (211), une seconde sous-partie (212) et une troisième sous-partie (213) empilées en séquence, la structure fonctionnelle (22) comprenant une quatrième sous-partie (224) et une cinquième sous-partie (225) empilées en séquence, une hauteur totale de la première sous-partie (211), de la seconde sous-partie (212) et de la troisième sous-partie (213) étant égale à une hauteur totale de la quatrième sous-partie (224) et de la cinquième sous-partie (225) ;
**caractérisé en ce que**, dans une direction parallèle à une surface du substrat, une largeur de la seconde sous-partie (212) est supérieure à une largeur de la première sous-partie (211) ; et
dans une direction parallèle à une surface du substrat, une largeur de la troisième sous-partie (213) est supérieure à la largeur de la seconde sous-partie (212) ;
dans une direction parallèle à une surface du substrat, la largeur de la première sous-partie (211) est égale à une largeur de la quatrième sous-partie (224) ; et
dans une direction parallèle à une surface du substrat, la largeur de la seconde sous-partie (212) est égale à une largeur de la cinquième sous-partie (2) ;
la première sous-partie (211), la seconde sous-partie (212) et la troisième sous-partie (213) sont formées intégralement ; et
la quatrième sous-partie (224) et la cinquième sous-partie (225) sont formées intégralement et
la première couche diélectrique (2) est une structure monocouche.

2. Structure semi-conductrice de la revendication 1, dans laquelle
la structure d'anneau d'étanchéité (21) comprend N sous-parties empilées en séquence, N étant un nombre entier supérieur à 3.

3. Structure semi-conductrice de la revendication 2, dans laquelle
dans une direction parallèle à une surface du substrat, les largeurs des N sous-parties empilées en séquence augmentent successivement.

4. Structure semi-conductrice de la revendication 1, comprenant en outre :
une couche métallique inférieure (11) positionnée sous la structure d'anneau d'étanchéité (21) et une structure d'interconnexion de la couche supérieure (31) positionnée au-dessus de la structure d'anneau d'étanchéité (21), respectivement ; dans laquelle
un matériau de la structure d'anneau d'étanchéité comprend du cuivre, un matériau de la couche métallique inférieure (11) comprend du tungstène, et un matériau de la structure d'interconnexion de la couche supérieure (31) comprend du tungstène ou de l'aluminium.

5. Procédé de fabrication d'une structure semi-conductrice, comprenant :
fournir un substrat (S1), le substrat comprenant une région périphérique et une région de puce ;
former (S2) une première couche diélectrique (2) sur la région périphérique et la région de puce du substrat ; et
former (S3) une structure d'anneau d'étanchéité (21) et une structure fonctionnelle (22) respectivement dans la première couche diélectrique (2) sur la région périphérique et dans la première couche diélectrique sur la région de puce ;
dans lequel la structure d'anneau d'étanchéité et la structure fonctionnelle sont formées par un matériau électriquement conducteur ;
dans lequel la structure d'anneau d'étanchéité comprend une première sous-partie (211), une seconde sous-partie (212) et une troisième sous-partie (213) empilées en séquence, la structure fonctionnelle (22) comprenant une quatrième sous-partie (224) et une cinquième sous-partie (225) empilées en séquence, une hauteur totale de la première sous-partie (211), de la seconde sous-partie (212) et de la troisième sous-partie (213) étant égale à une hauteur totale de la quatrième sous-partie (224) et de la cinquième sous-partie (225) ;
**caractérisé en ce que**, dans une direction parallèle à une surface du substrat, une largeur de la seconde sous-partie (212) est supérieure à une largeur de la première sous-partie (211) ; et
dans une direction parallèle à une surface du substrat, une largeur de la troisième sous-partie (213) est supérieure à la largeur de la seconde sous-partie (212) ;
dans une direction parallèle à une surface du substrat, la largeur de la première sous-partie (211) est égale à une largeur de la quatrième sous-partie (224) ; et
dans une direction parallèle à une surface du substrat, la largeur de la seconde sous-partie (212) est égale à une largeur de la cinquième sous-partie (2) ;
la première sous-partie (211), la seconde sous-partie (212) et la troisième sous-partie (213) sont formées intégralement ; et
la quatrième sous-partie (224) et la cinquième sous-partie (225) sont formées intégralement et
la première couche diélectrique (2) est une structure monocouche.

6. Procédé de fabrication d'une structure semi-conductrice de la revendication 5, dans lequel
la structure d'anneau d'étanchéité (21) formée comprend N sous-parties empilées en séquence, N étant un nombre entier supérieur à 3.

7. Procédé de fabrication d'une structure semi-conductrice de la revendication 6, dans lequel
dans une direction parallèle à une surface du substrat, les largeurs des N sous-parties empilées en séquence augmentent successivement.
